# EUROPEAN PATENT SPECIFICATION

(11) **EP 2 040 086 B1**
(45) Date of publication and mention of the grant of the patent: **15.08.2018**
(21) Application number: 07291123.3
(22) Date of filing: 21.09.2007
(51) Int. Cl.: G01R 29/12, G01R 29/24, A61B 5/0408, A61B 5/0478, G01V 3/08

(54) **Sensor for non-contact electric field measurements**
Sensor für kontaktlose Messungen elektrischer Felder
Capteur de mesure de champ électrique sans contact

(43) Date of publication of application: 25.03.2009
(73) Proprietor: SYSNAV, 27200 Vernon (FR); Université de Caen Basse Normandie, 14000 Caen (FR)
(72) Inventor: Robbes, Didier, 14480 Lantheuil (FR)
(74) Representative: Grünecker Patent- und Rechtsanwälte PartG mbB

(56) References cited:
- EP-A- 0 645 635
- WO-A-98/52147
- WO-A-02/063343
- WO-A-03/048789
- US-A1- 2003 042 907
- US-A1- 2006 006 877

## Description

The present invention relates to a probe and a sensor for measuring electric fields, more specifically to a probe that in combination with an electrometer allows measurement of an electric field with high sensitivity, large bandwidth and low frequencies without making electrical contact.

Most conventional electrometers measure very small currents in order to render the measurement of an electric field possible. The electrometers have an ultra high input impedance in order to minimize the influence of the measurement on the field to be measured.

Field measurements that require electrical contact are often not possible or desirable, for example in the field of geophysics (mining prospecting, hydrography), biomedical technique (general electrophysiology, electrocardiography, and electroencephalography), measuring of electromagnetic fields, the detection of moving objects and for educational purposes.

International patent application WO 03/048789 describes an example of an electrodynamic sensor that does not need electrical contact with an object under test. The sensor has two probes connected to an electrometer. The electrometer comprises a differential amplifier to reduce noise and high input impedance so that little power is drawn from the received field. The high input impedance is obtained by combining different circuit techniques, such as guarding, bootstrapping and neutralisation.

International patent application WO 98/52147 discloses a fingerprint sensor comprising an array of electric field sensing electrodes separated by shield electrodes. A capacitor can only be formed in the presence of a finger.

Improvements of sensors known from the prior art are desirable where sensitivity, bandwidth and the measurement of fields with very low frequencies down to static fields are concerned. Further improvement of performance can be obtained when the disturbance of the field to be measured by the probe can be reduced.

The object of the present invention is to provide a probe and a sensor for electromagnetic field measurements that improves the above-mentioned aspects of the prior art.

This object is achieved by a probe according to claim 1.

The object of the present invention is to provide a probe and a sensor for electromagnetic field measurements that improves the above-mentioned aspects of the prior art.

This object is achieved by a probe comprising a means for concentrating the electric field to be measured and a signal capacitor, wherein the means for concentrating the electric field to be measured comprises a structure of two tapered bodies. The tapered shapes have the advantage that the electric field to be measured becomes concentrated between the plates of the signal capacitor. Due to this concentration it becomes possible to measure low field values. Indeed, a probe of high sensitivity being capable of measuring electric fields from as low as a few µVm⁻¹ is achieved.

In a preferred embodiment of the invention the tapered bodies of the means for concentrating the electric field can have a symmetry axis, a base, and a truncation section with a surface area smaller than that of the base, the symmetry axis connecting the centre of the truncation section and the centre of the base of the tapered body, the truncation section and the base being perpendicular to the symmetry axis, the tapered bodies being arranged with the truncation sections opposing each other at a certain distance and their axes coinciding, the signal capacitor being electrically connected to the truncation sections. In this configuration the sensitivity is further improved.

Preferably, the tapered bodies of the means for concentrating the electric field can be in the form of truncated cones or pyramids. Adopting that shape for the tapered bodies optimizes the amplifying properties and facilitates manufacturing of the tapered bodies.

According to a preferred embodiment the tapered bodies have essentially the same shape. This provides mirror symmetry with respect to the plane of the signal capacitor to the probe further improving the sensing properties of the probe.

Advantageously, the means for concentrating the electric field to be measured can be formed of an isolating dielectric material with a relative dielectric constant of at least unity, preferably of the order of 100. This choice of material provides a probe with high sensitivity, wide bandwidth and operational frequencies down to quasi-static fields.

According to a variant, the means for concentrating the electric field to be measured is formed of a conducting material with a conductivity of at least 10⁶ Ωm, in particular 10⁶ Ω m to 10⁷ Ωm. This choice of material provides a probe with high sensitivity, wide bandwidth and operational frequencies down to low frequencies.

In a preferred embodiment of the invention the signal capacitor can be provided in the form of a surface mounted component. Such capacitors are available with very small capacitances, so that the sensitivity of the probe can be enhanced.

In another preferred embodiment, the signal capacitor can be formed by metalized parts of the truncation sections facing each other. This choice of capacitor has the advantage, that it is easily manufactured, while preserving the probe symmetry.

In another preferred embodiment, the signal capacitor can be provided on an insulating membrane, wherein the metallic electrodes of the signal capacitor are formed on the membrane and positioned in contact with the truncated sections. This provides a simplified arrangement, which is easy to realize and renders the device robust.

In another embodiment of the invention, the probe can further comprises one or more bodies having a shape complementary to that of the tapered bodies, the bodies being made of a material with a relative dielectric constant close to unity, and in contact with the tapered surface of the tapered bodies. This feature provides additional rigidity to the structure and at the same time a perturbation of the electric field can be kept low.

In a preferred embodiment of the invention, two capturing means, in particular metallic electrodes, can be provided, one on the base of each tapered body, so that the electromagnetic field to be measured is more effectively captured, thus improving the sensitivity of the probe.

Advantageously, the capturing means can be replaced by a dielectric material. The dielectric has the advantage that the operational frequencies of the probe are not restricted in the low frequency to static field case based on the skin effect in conducting media.

According to another preferred embodiment, a compensation electrode can be provided near the base of each tapered body. Preferably, the compensation electrodes can have an opening in the centre, and both the outer shape of the compensation electrodes and the shape of the opening match the shape of the capturing means. The compensating electrodes allow nulling the electric field inside the volume that is delimitated by the probe and allows for improved field determination.

Preferably the compensation electrodes can be provided in a coplanar manner with the capturing means. This offers the advantage of realizing small values of the coupling capacitance between the capture electrode and the adjacent compensation electrode, which are typically in the pF or sub pF range. Small capacitance values are important when a large voltage signal applied to the compensation electrodes is desired to counteract small external fields to be measured.

According to an alternative, the compensation electrodes can be provided on the side of the capturing means opposite to the tapered body with an intervening insulating layer. This configuration reduces the size of the probe, while allowing larger values of the coupling capacitance between the capture electrode and its front compensation electrode, when required by certain specifications of applications, especially those requiring the counteracting of large external fields. Furthermore, this way of realization is easier, reducing mechanical manipulations and assembly.

According to a further embodiment of the invention the probe according to any of the embodiments described above, can be combined with an electrometer to form an electromagnetic sensor. This sensor shares all the advantages of the corresponding probe.

Preferably, the sensor may further comprise a means to vibrate or rotate the probe along an axis perpendicular to the axes of the tapered bodies. In this way it is possible to also determine static fields on limited bandwidth, in particular using spectral transformation techniques. It should be considered that any rotating or vibrating body in the vicinity of the probe would produce similar spectral transformation, acting in a way similar to a mechanical chopper in optics

In another embodiment of the invention, the signal capacitor comprises a dielectric material with a nonlinear response to an electric field. In that way, measurements down to static fields become also possible, without moving parts, which enlarge the bandwidth.

In an advantageous embodiment, the electrometer of the sensor can comprise a fully differential amplification circuit connected to the electrodes of the signal capacitor for amplifying the signal. In this embodiment of the invention, the compensation electrodes can be connected directly to the fully differential stage outputs of the amplification circuit. In that way, phase inversion by simple reversal of connecting wires, is achieved without adding active structures in the direct line, and the stability of the system is obtained in a simple and robust way, while a high gain is allowed on the amplifying stage. The latter is essential to make the output noise contribution of head amplifiers neglectable.

A probe according to another aspect of the invention comprises a compensation electrode to nullify the local field inside the active volume of the probe. The compensation electrodes function is to null the local electric field inside the active volume of the probe, typically using a servo loop. The potential difference between the signals applied to the compensation electrodes to compensate the electric field in the probe, divided by a value of length, which can be determined out of the geometry of the probe, gives access to the strength of the electric field.

Preferably, the probe of this embodiment can further comprises a means for concentrating the electric field to be measured and a signal capacitor, wherein the means for concentrating the electric field to be measured preferably comprises a structure of two tapered bodies, in particular truncated cones or pyramids, each tapered body having a symmetry axis, a base, and a truncation section with a surface area smaller than that of the base, the symmetry axis connecting the centre of the truncation section and the centre of the base of the tapered body, the truncation section and the base being perpendicular to the symmetry axis, the tapered bodies being arranged with the truncation sections opposing each other at a certain distance and their axes coinciding, and wherein the signal capacitor is electrically connected to the truncation sections. In a probe with those features, the compensation electrodes are particularly effective and due to the amplifying effect of the truncated structures the probe has a high sensitivity and at the same time functions over a large range of electric fields (up to several thousands of V/m.

In this embodiment, the tapered bodies can be formed of an isolating dielectric material with a relative dielectric constant of at least unity, preferably of the order of 100, and two capturing means are provided, one on the base of each tapered body, the capturing means having the same shape as the base. With this structure an effective concentration can be achieved.

Advantageous embodiments will be described in the following in relation to the following figures, wherein:
- Fig. 1: illustrates a probe for measuring electric fields according to embodiment 1,
- Fig. 2: illustrates equipotential lines of the electric field around the probe according to embodiment 1 show the amplification effect in the centre of the double-cone device,
- Fig. 3: illustrates a variant of embodiment 1, wherein the electrodes of the signal capacitor are formed on a membrane, which is then positioned in contact with the truncated sections of the cones and the volume between the two capturing electrodes is filled with a material with a relative dielectric constant close to unity,
- Fig. 4: illustrates a probe for measuring electric fields according to embodiment 2,
- Fig. 5: illustrates the disturbing influence of the probe of embodiment 2 on an electric field to be measured when compensation electrodes are not activated,
- Fig.: 6aillustrates the electric field around the probe of embodiment 2, when the compensation electrodes have a negative potential relative to the symmetry plane of the device, perpendicular to the symmetry axis,
- Fig 6b: illustrates the signal picked up at the signal capacitor, in case the signals applied to the compensation electrodes have slightly different frequency than the one of the outside electric field,
- Fig. 7: illustrates another example of a probe according to embodiment 2,
- Fig. 8: illustrates a third embodiment, namely a biaxial probe, adapted to measure electric field intensities in two orthogonal directions,
- Fig. 9: illustrates a fourth embodiment, namely a configuration for gradiometric measurements with two sensors, and
- Fig. 10: illustrates a sensor according to embodiment 6 of the invention, comprising a probe and an amplifying circuit with a first fully differential stage with two operational amplifiers and a second, non-differential stage with one operational amplifier.

The present invention provides a probe for an electromagnetic sensor and an electromagnetic sensor comprising the probe, and an electrometer adapted to condition and amplify the signal provided by the probe. The invention is based on the laws of classical electrodynamics, making use of the theory of displacement currents. The electric field to be measured is concentrated using bodies with a tapered shape. The invention is exemplified by the following embodiments.

### Embodiment 1

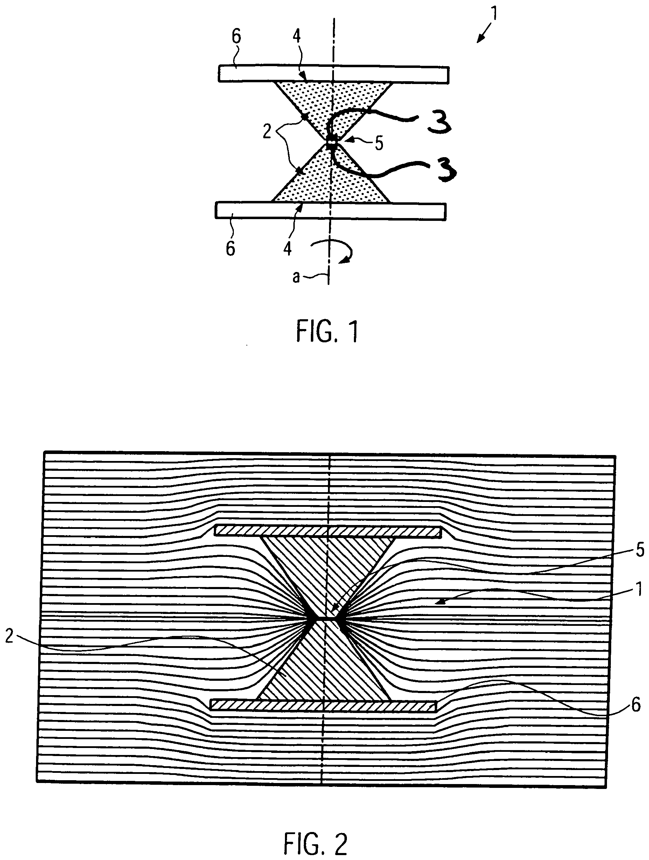

Fig. 1 illustrates a side cut view of a probe according to a first embodiment of the invention. The structure of the probe 1 of this embodiment can be described as a double cone, comprising two truncated cones 2 placed so that the truncated sections 3 face each other. Both the base 4 of the truncated cones 2 and the truncated section 3 of each cone are perpendicular to the axis a of the cone, wherein the axis a is defined as the line connecting the imaginary apex of the cone with the middle of the base 4. The truncated cones 2 are arranged so that their axes overlap, and the common axis a forms the symmetry axis of the double cone structure. The opening angle of each cone is in the order of 90°. The invention is however not limited to this angle and the opening angle can also be any one in the range of 30° to 120°.

In this embodiment, the area of the base 4 is in the order of 1 cm² and the smaller, truncated section 3 has an area of some mm². These values can be chosen from a large range, provided that the area of the base 4 is sufficiently, in particular be a factor of 50 to 100 different from that of the truncated section 3 of the cones.

The cones 2 are preferably formed from an insulating material with a high value of the relative dielectric constant of at least 100. In this embodiment, ceramic barium titanate (BaTiO3) was used, which has a relative dielectric constant of the order of 500. The leakage current in this material is considered extremely weak, the equivalent electric resistance being at least higher than 1 TΩ.

Between the two cones a capacitor 5 is provided. In this embodiment, a capacitor 5 in the form of a surface mounted component is chosen. Other possibilities are discussed below. The capacitor 5 typically has a capacitance of the order of 10 pF to some 10 nF.

The contact between the ceramic material of the cones 2 and the electrical connections of the capacitor 5 is provided by a very thin electric wire (not shown) with a diameter of within a range of 50 to 100 µm. On the truncated side of the cones 2, a small hollow is formed in which the thin wire is inserted. The hollow is subsequently filled with a metallic material of high conductivity and high ductility, like for example Indium or Wood's metal, so that an excellent contact is obtained between the cones 2 and the capacitor 5. When the truncated cones 2 and the capacitor 5 are assembled, the two wires are connected with the centre cores of two coaxial cables respectively. In this embodiment, the electrodes of the signal capacitor 5 are parallel to the base 4 and the truncated section, which ensures best results.

The base sections 4 of the cones 2 are levelled and polished, and a polished metallic capturing electrode 6 is stuck to each of them. The diameters of the two capturing electrodes 6 are identical and larger than the diameter of the base sections 4. Their thickness can be chosen in order to comply with the desired specifications.

The probe 1 functions in the following way: It amplifies an external electric field captured by the capturing electrodes 6 by concentrating the field between the electrodes of the signal capacitor 5 on the other end of the truncated cones 2. The amplification factor depends on the geometry of the truncated cones 2 and the metallic electrodes of the signal capacitor 5.

Fig. 2 demonstrates the amplification effect of the double cone structure of embodiment 1 on an electric field. The lines represent equipotentials of the electric field with a distance of 50 mV. The external field is 100 Vm⁻¹. The average field at the centre is about 3500 Vm⁻¹, so that an amplification factor of 35 is attained. That is close to the ratio of the distance between the capturing electrodes 6 and the distance between the electrodes of the signal capacitor 5, which in the shown example was 10mm/0.3mm thus corresponding to 33,3. Figure 2 also shows that the probe 1 does only cause a significant deformation of the electric field lines in the volume delimited by the two capturing electrodes 6 and essentially keeps the field unaffected outside this volume.

Certain variations of the probe 1 of embodiment 1 will be described in the following. In embodiment 1, the bodies of dielectric material forming the means for concentrating the captured electric field are in the form of truncated cones 2. The cone shape is particular effective for this purpose, as a high amplification can be obtained. The cone shape is also favourable for its highly symmetric geometry and the ease with which it can be realized and worked on. However, the bodies do not have to be exactly cone-shaped. The cones could be replaced by bodies of other shape, as long as the electric field captured on a section with a larger diameter is guided to a section with a smaller diameter. In general all tapered bodies can therefore be used. The bodies should preferably have a symmetry axis connecting the centre of the two end surfaces, which in analogy to the truncated cone 2 can be called the base and the truncated section. Those end surfaces are preferably perpendicular to the symmetry axis. Another example of such tapered bodies are truncated pyramids, which can also form the basis for a sensitive probe. The base of the pyramids can be square, polygonal or, for example, rectangle.

The dielectric bodies of embodiment 1 are made of BaTiO₃. However, many other materials, like compounds with perovskite structure, e.g. ACu₃Ti₄O₁₂, or CaCu₃Ti₄O₁₂ which exhibit values higher than 10⁴, can be used for that purpose, as long as the permittivity of the material is high, together with high resistivity or those materials commonly used in ceramic capacitor manufacturing.

The choice of a highly polarisable material leads to a very low electric field within the cones. The internal field would be zero in the case of an infinite dielectric constant. The large relative reduction of the internal electric field, in combination with the conditions on the borders forming the interface between different materials, leads to a localized amplification of the electric field between the electrodes of the signal capacitor 5. Important characteristics of the material to be used are a high resistivity and a small loss in the high frequency part of the frequency spectrum of interest for a certain use of the invention. The mentioned parameters are important for the performance of the device, especially regarding its intrinsic noise.

The cones or otherwise shaped tapered bodies forming the means for concentrating the captured electric field do, however, not have to be made of a material with very high dielectric permittivity in any case. Alternatively, they could be made of a material with a very high electric conductivity (metallic or otherwise, like superconductive), e.g. of the order of or above 10⁶Ωm. In that case the surface charge density on the surface of the cones is distributed in such a way that the internal field in the conductor is very weak (zero in the ideal case of infinite conductivity). Therefore, the surface conditions for the electric field are the same in the case of a material of high electric conductivity as for a material of high permittivity and the device will function in a similar way.

There is a difference, however, because in materials with high but finite conductivity the skin effect affects the functioning at very low frequencies.

The probe of embodiment 1 also functions without capturing electrodes 6. However, such a small simplification will cause deterioration in performance, especially concerning the capturing of the electric field at the base 4 of the cones 2. Nevertheless the capturing properties of such a structure could be improved by optimizing the shape of the cones, in particular by enlarging the base of the cone to obtain a form of the modified cone being similar to the form of the cone and the capturing electrodes combined into one structure.

In a variation of embodiment 1, the conical parts 2 of the device may have a size that would allow forming a cavity therein. This cavity could, for example, be used to provide a conditioning circuit, an energy source and/or a radio communication means inside. In that way, the symmetry of the probe is not disturbed by connections to the electronic part of the sensor.

A further possible variation of embodiment 1 concerns the way the signal capacitor 5 is implemented in the probe 1. Instead of providing a separate capacitor in the form of a surface mounted component (SMC), the truncated sections 3 can each be covered with a metallic layer, in part or completely, and placed at a certain distance. The capacitor 5 is then defined by the metallic layer forming the electrodes and their separation through a medium with a low relative dielectric constant, e.g. A value much lower than that of the tapered bodies. In that case, the amplification factor depends directly on the ratio of the distances of the electrodes of the thus formed signal capacitor 5 on one side and the capturing electrodes 6 on the other side. This variation of embodiment 1 has the advantage that the delicate operations to put a SMC capacitor in place (3D arrangement) are not necessary.

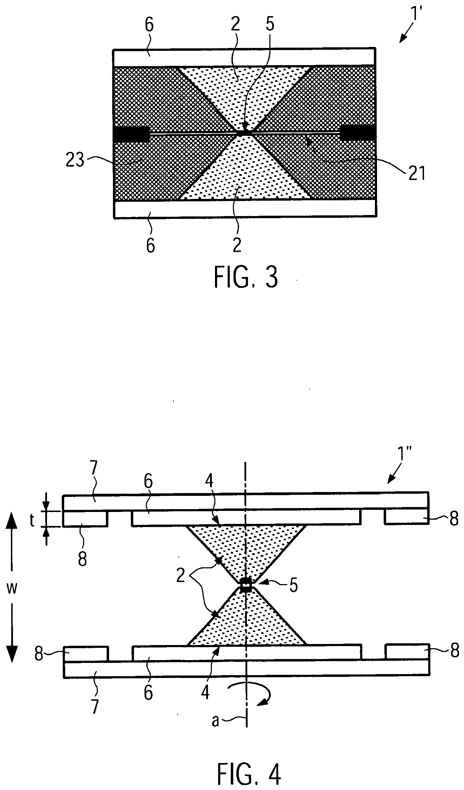

Alternatively, the electrodes of the signal capacitor 5 can be formed on both sides of an insulating membrane 21, which is then placed in between and in contact with the truncated sections 3 of the cones 2, as depicted in Fig. 3. Also this way to implement the signal capacitor 5 facilitates the manufacturing of the probe, here carrying the reference numeral 1'. A further advantage is that this solution does not disturb the symmetry of the probe 1' in the vicinity of the signal capacitor 5. Furthermore, the signal can be taken from the electrodes of the signal capacitor 5 by forming wiring on the membrane applying e.g. microphotolithographic techniques. The membrane can be of Mylar, for example, or any membrane material commonly used in high frequencies applications.

In another variation of the probe 1 of embodiment 1 and which is also illustrated in Figure 3, all or part of the space around the tapered surfaces of the truncated cones 2 and between the capturing electrodes 6 can be filled with a material of low relative dielectric constant, which only introduces a slight perturbation of the electric field lines. By providing such counter forms 23 of the conically shapes of the guiding bodies 2, the rigidity of the probe 1' is significantly improved.

The truncated cones 2 of embodiment 1 have the same shapes, so that mirror symmetry with respect to the signal capacitor is achieved, which further improves the qualities of the probe. This additional symmetry is, however, not mandatory as long as the desired amplification can be achieved, so that the form of both cones may vary.

It should be understood that each one of the variations on embodiment 1 described above could be implemented separately or in combination with one or more of the other variations.

### Embodiment 2

A probe 1", according to embodiment 2 of the invention is depicted in Figs. 4 to 6. These figures are compatible with certain variations on embodiment 1 described above. However, the features characterizing embodiment 2 can be combined with each of the variations described and a combination thereof. Elements carrying the same reference numerals as in embodiment 1 have the same properties and their description is not repeated again in detail but incorporated herewith by reference.

Embodiment 2 differs from embodiment 1 in that additional compensation electrodes 8 are provided in order to essentially nullify the electric field inside the volume that is delimited by the probe 1", to improve the determination of the electric field to be measured which is based on the potentials applied to the compensation electrodes.

In the embodiment depicted in Fig. 4, a thin dielectric plate 7, for example made of glass or epoxy, is fixed to each one of the two capturing electrodes 6. Each dielectric plate 7 supports a compensation electrode 8 in the form of a conducting ring, centred on the symmetry axis a of the probe 1". The inner diameter of the compensation electrodes 8 is chosen to be larger than the external diameter of the capturing electrodes 6 and each compensation electrode 8 is provided in a coplanar manner with the corresponding capturing electrode 6.

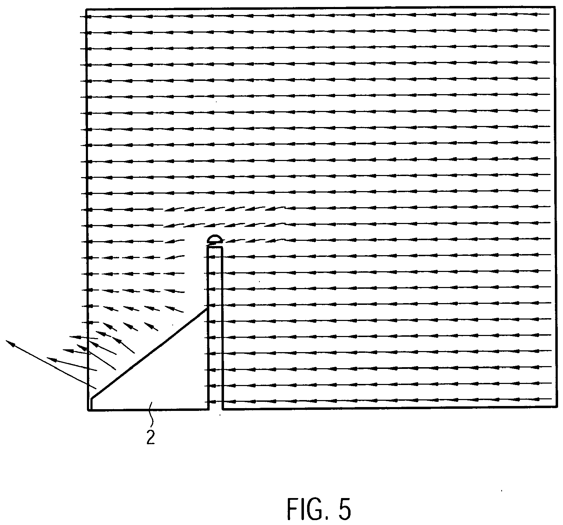

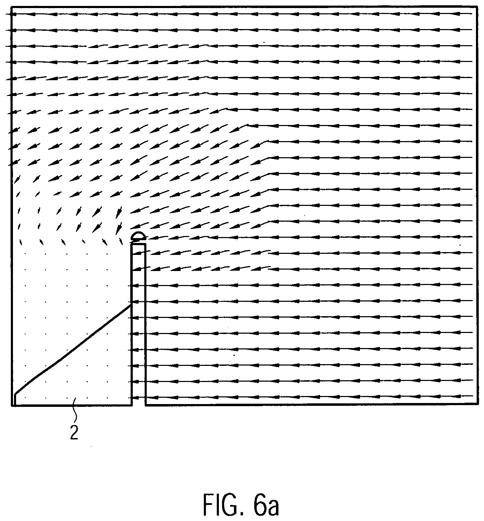

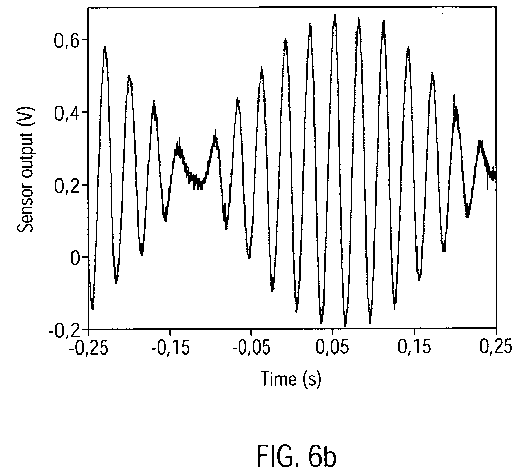

Figs. 5, 6a and 6b show the effect of the compensation electrodes 8. Contrary to Fig. 2, Figs. 5 and 6a show the local field direction and strength using arrows. In Fig. 5, the potential of the compensation electrodes 8 provided around the capturing electrodes 6 is left floating. In Fig. 6a, the compensation electrodes 8 are given a negative potential relative to the plane of symmetry positioned at the left border of the figure. The external electric field is not equal to zero. The value of the potential difference of the compensation electrodes 8 is chosen such that the electric field in the centre of the probe (lower left corner of the figure) is compensated. The value of the effective field within the cylindrical volume delimited by the compensating electrodes 8 is close to zero, showing the nulling properties of the device, while the outer field lines are not so changed with respect to Fig. 5. This means that the outer disturbance to the measured field is still low.

Figure 6b illustrates the signal obtained at the signal capacitor 5, when the probe 1" is positioned in an external alternating electric field and a compensation signal with a slightly different frequency is applied to the compensation electrodes 8. The clear beating of the signal illustrates that the amplitude of the potentials applied to the compensation electrodes 8 was correctly chosen such that the electric field was compensated at the signal capacitor 5. From the signals applied to the compensation electrodes the electric field properties can then be extracted.

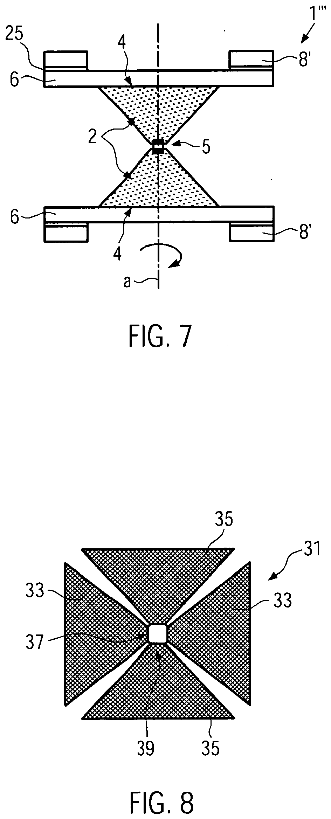

Fig. 7 shows a variation of embodiment 2. The compensation electrodes 8' are provided in a sandwich structure of capturing electrode 6, insulating layer 25 and compensation electrode 8'. The advantage of this configuration is that the outer dimensions of the probe are smaller, together with improving the fabrication process.

With both configurations it is possible to nullify the electric field inside the volume of the probe 1", 1''' with an electric field equivalent to the disturbance in the opposite direction using the compensation electrodes 8.

The potential difference between the signals returned to the compensation electrodes 8 divided by a transfer parameter L₁ with the dimension of a length, yields a numerical value of the projection of the electric field on the symmetry axis of the probe. The value of the transfer parameter L₁ depends essentially on the geometric characteristics of the electrodes. In order to facilitate the use of the probe 1", 1''', it is possible to determine the geometric conditions in such a way that the measured electric field corresponds directly to the opposite of the difference of the potential between the compensation electrodes 8 divided by the physical length separating the capturing electrodes 6.

The compensation in the form of an electric field as described here achieves advantages concerning dynamic performance and bandwidth. The thickness t of the capturing electrodes 6 and the compensation electrodes 8 is one of the parameters of the device that can be adjusted, as well as the distance w between those electrodes, the important factor being the ratio w/t. In that manner, the numerical value of the compensation capacitance defined between a capturing electrode 6 and its compensation electrode 8 can be adjusted over a large range including several orders of magnitude, at least from a fraction of a pF to several tens of nF. Numerical estimates are obtained directly from the ratio w/t and the plan capacitor formulae. Improved estimates are obtained using numerical tools. The range is wide, because the ratio w/t may be varied on a large range. As shown, the probe1", 1''' of embodiment 2, functioning as an electromagnetic sensor, only slightly deforms the electric field lines around it and has an active volume comparable to its physical dimensions, thereby further improving the characteristics of the probe of embodiment 1.

According to variants, additional electrodes could be supplied as secondary compensation electrodes in order to compensate a possible offset and/or to supply a modulation signal for the capturing electrodes 6. That could be necessary in view of certain signal treatments, for example in order to reduce the background noise.

When using the counter forms 23 of one of the variants of embodiment 1, additional electrodes could also be arranged by applying an electrode layer around the counter forms 23, in particular in a cylindrical manner

### Embodiment 3

According to the third embodiment, two or three probes with the double cone structure according to embodiments 1 or 2 are combined in such a fashion that their sensitivity directions (symmetry axes) are different, and in particular orthogonal with each other, so that a probe is obtained that can measure both intensity and direction of the electric field in the vicinity of the probe. This arrangement is illustrated in Fig. 8, which represents a side cut view of the probe 31 according to the third embodiment and shows the two orthogonally arranged pairs of cones 33 and 35 with their respective signal capacitors 37 and 39.

### Embodiment 4

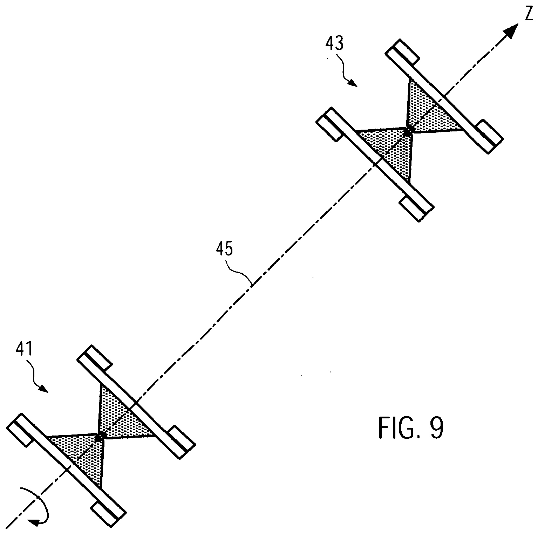

According to the fourth embodiment, illustrated in figure 9, two or more probes 41, 43 according to embodiments 1 or 2 could be placed on a straight line 45 with the symmetry axes of the probe parallel to that line. With this configuration it becomes possible to determine the derivative of the electric field component in the direction of the line, as one probe measures E_{z}(z) and the other one E_{z}(z+dz), with z being the direction along line 45. By turning the arrangement by 90° with respect to line 45 the derivative along the other direction can be obtained in the same way. In that way, contributions of distant field sources can be greatly eliminated.

According to a variant the probes could be arranged in a matrix and either all aligned along the same direction or with some probes being aligned in a direction perpendicular

### Embodiment 5

The probe according to embodiments 1 or 2 has a symmetry plane perpendicular to its symmetry axis. According to embodiment 5, the probe is furthermore configured such that it can be vibrated or rotated around an axis in that symmetry plane and by using spectral transformation techniques the field strength of static electric fields and fields varying with very low frequencies (<10Hz) can be measured.

In case that the electric field measurement is desired for la large bandwidth, a further improvement consists in using non linear dielectric materials with a low coercive field.

It should be notified, that the inventive probe topology comprising capturing means made of metallic electrodes 6 and no compensation electrodes, has the topology of an ac current transformer whose ratio is unity, and that acts just like a known voltage transformer made from magnetic materials and copper wiring. Higher current transformer ratios are obtained by serially adding proper ceramic bodies with their electrodes and a proper wiring between the said electrodes.

### Embodiment 6

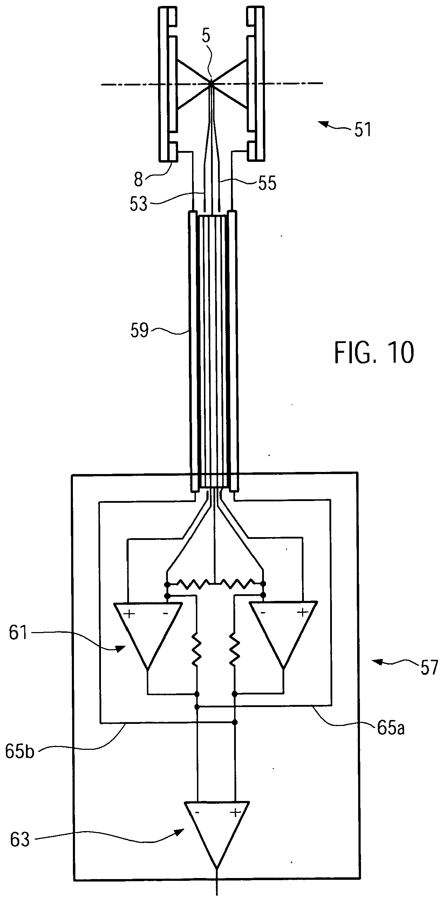

Figure 10 illustrates a sensor according to embodiment 6 of the invention. The sensor 51 comprises one of the probes according to embodiments 1 to 5 and, in addition, an inventive electrometer, which amplifies and transforms the signal on the signal capacitor 5 to a value of the measured electric field.

The centre cores of coaxial cables 53, 55, connected to the electrodes of the signal capacitor 5 are connected to the two inputs of the inventive amplification circuit 57. The structure of the amplifier circuit 57 is an instrumentational amplifier with three operational amplifiers. This structure satisfies the requirements of an amplifier of the electrometer type: high input impedance (> 10 TΩ), low polarisation current (< 1 pA), low current noise (1 < fA/ √Hz), low voltage noise (< some tens of nV/ √Hz). The prepolarisation of the inputs of the amplifier is obtained in the classical fashion by resistance components of high values (> 50 GΩ), and a classical boot strapping technique, which allows keeping the major part of the input impedance of the amplifying structure (not shown). A standard guarding 59 is applied to the common mode signal and the differential signals, in order to limit the effects of imperfections of the wiring.

In this electrometer amplifier circuit 57, the invention introduces a feature that is necessary in order to provide a voltage for the compensation electrodes 8. In this embodiment, the compensation signals are obtained from the electrometer circuit before the transformation from differential amplification 61 to non-differential amplification 63. Taking the signal directly at the output 65a, 65b of the first fully differential amplification stage 61 with a single operational amplifier per input, has the advantage that the signals can be directly applied to the compensation electrodes 8. The necessary inversion of the phase is obtained only by inversing the wiring, without having to add an active element and its inherent supplementary pole, the position of which limiting the gain of the direct chain, given suitable gain and phase margins. Thus, the stability of the system is achieved in a convenient way.

It is important to mention that the inventive amplifier circuit 57 cannot only advantageously be used in applications used to measure electric fields, but by exchanging the probe 51 by a magnetometer, the same advantageous effects, like the stability of the system due to the inversing of wiring, can be achieved when measuring magnetic fields. Thus the invention also relates to a sensor comprising a magnetometer and the amplifier circuit 57 as described above.

The sensor according to the invention, particularly the one comprising the probe of embodiment 2 including compensation electrodes 8, has number of advantages of technical and economical nature over those know from the prior art. The probe only causes a very small amount of deformation of the electric field lines outside of its immediate vicinity. The sensor can be used in two modes: in direct mode without activating the compensation electrodes 8, or in compensation mode, counteracting the electric field. In both modes the sensor indicates the value of the projection of the electric field vector on its symmetry axis. In particular, the compensation mode brings the invention the advantages of a stable base line, linearity, less susceptible to aging.

Numerous prior art devices need at least one galvanic contact in order to provide a reference voltage. The present device operates without any contact. It automatically obtains a reference voltage from the guarding provided to shield the signal lines.

The sensor has good dynamical characteristics. In the compensation mode the following specifications were obtained for the device:
Bandwidth: at least 8 decades of frequency;
Sensitivity: Sₙ^{E} = 100 µVm⁻¹/√Hz;
Dynamical range: 180 dB attainable.

The dimensions and values of components given above are not limiting, but can be varied. Since the effect of such variation can in principle be calculated, specifications of the sensor can be made to match those needed for specific applications of the sensor.

## Claims

1. A probe for measuring electric fields, comprising:
a means for concentrating the electric field to be measured;
and a signal capacitor (5), said probe is **characterised in that**
the means for concentrating the electric field to be measured comprises a structure of two tapered bodies (2) arranged such that the electric field captured on a section with a larger diameter is guided to a section with a smaller diameter, and the signal capacitor (5) is a capacitor provided between the two tapered bodies (2).

2. The probe according to claim 1 wherein the tapered bodies of the means for concentrating the electric field have a symmetry axis, a base (4), and a truncation section (3) with a surface area smaller than that of the base (4), the symmetry axis connecting the centre of the truncation section (3) and the centre of the base (4) of the tapered body, the truncation section (3) and the base (4) being perpendicular to the symmetry axis, the tapered bodies being arranged with the truncation sections (3) opposing each other at a certain distance and their axes coinciding; and
the signal capacitor (5) is electrically connected to the truncation sections (3).

3. The probe according to claim 1 or 2, wherein the tapered bodies of the means for concentrating the electric field are in the form of truncated cones (2) or pyramids.

4. The probe according to one of claims 1 to 3, wherein the means for concentrating the electric field to be measured is formed of an isolating dielectric material with a relative dielectric constant of at least 100.

5. The probe according to one of claims 1 to 3, wherein the means for concentrating the electric field to be measured is formed of a conducting material with a conductivity of at least 10⁶(Ωm)⁻¹.

6. The probe according to any one of claims 1 to 5, wherein the signal capacitor (5) is provided in the form of a surface mounted component.

7. The probe according to any one of claims 2 to 5, wherein the signal capacitor (5) is provided in the form of metalized parts of the truncation sections (3) facing each other.

8. The probe according to any of claims 2 to 5, wherein the signal capacitor (5) is provided on an insulating membrane (21), the metallic electrodes of the signal capacitor (5) are formed on the membrane (21) and positioned in contact with the truncation sections (3).

9. The probe according to any of claims 1 to 8, further comprising:
one or more bodies (23) having a shape complementary to that of the tapered bodies (2), made of a material with a relative dielectric constant close to unity, and in contact with the tapered surface of the tapered bodies (2).

10. The probe according to any of claims 1 to 9, further comprising:
two capturing means (6), one provided on a base (4) of each tapered body (2).

11. The probe according to claim 10, wherein the capturing means (6) is metallic.

12. The probe according to claim 10, wherein the capturing means (6) are made of a dielectric material.

13. The probe according to one of claims 1 to 12, wherein a compensation electrode (8) is provided near the base (4) of each tapered body (2).

14. The probe according to claim 13, wherein the compensation electrodes (8) have an opening in the centre, and both the outer shape of the compensation electrodes (8) and the shape of the opening match the shape of capturing means (6), one provided on a base (4) of each tapered body (2).

15. The probe according to claim 13 or 14, the compensation electrodes (8) are provided in a coplanar manner with capturing means (6), one provided on a base (4) of each tapered body (2).

16. The probe according to any of 13 or 14, wherein the compensation electrodes (8) are provided on the side of the capturing means (6) opposite to the tapered body (2) with an intervening insulating layer (25).

17. The probe according to any of claims 1 to 16, wherein the signal capacitor (5) comprises a dielectric material with a nonlinear response to an electric field.

18. A sensor comprising the probe according to any of claims 1 to 17 and an electrometer.

19. The sensor of claim 18, further comprising a means to vibrate or rotate the probe along an axis perpendicular to the axes of the tapered bodies.

20. The sensor according to claim 18 or 19, wherein the electrometer comprises a differential amplification circuit connected to electrodes of the signal capacitor (5) for amplifying the signal.

21. The sensor according to claim 20, wherein compensation electrodes (8) are connected to the fully differential stage of the amplification circuit.

## Patentansprüche

1. Sonde zur Messung elektrischer Felder, mit:
einer Einrichtung zur Konzentrierung des zu messenden elektrischen Feldes; und
einem Signalkondensator (5),
wobei sich die Sonde dadurch auszeichnet, dass
die Einrichtung zur Konzentrierung des zu messenden elektrischen Feldes eine Struktur aus zwei konischen Körpern (2) aufweist, die derart angeordnet sind, dass das auf einem Abschnitt mit einem größeren Durchmesser erfasste elektrische Feld zu einem Abschnitt mit einem kleineren Durchmesser geführt wird, und der Signalkondensator (5) ein Kondensator ist, der zwischen den zwei konischen Körpern (2) vorgesehen ist.

2. Sonde nach Anspruch 1, wobei die konischen Körper der Einrichtung zur Konzentrierung des elektrischen Feldes eine Symmetrieachse, eine Basis (4) und einen Abschneidungsabschnitt (3) mit einer Fläche aufweisen, die kleiner ist als diejenige der Basis (4), wobei die Symmetrieachse den Mittelpunkt des Abschneidungsabschnitts (3) und den Mittelpunkt der Basis (4) des konischen Körpers verbindet, und wobei der Abschneidungsabschnitt (3) und die Basis (4) senkrecht zu der Symmetrieachse liegen, wobei die konischen Körper so angeordnet sind, dass die Abschneidungsabschnitte (3) mit einem gewissen Abstand einander gegenüberliegen und ihre Achsen zusammenfallen; und
der Signalkondensator (5) mit den Abschneidungsabschnitten (3) elektrisch verbunden ist.

3. Sonde nach Anspruch 1 oder 2, wobei die konischen Körper der Einrichtung zur Konzentrierung des elektrischen Feldes in Form eines abgeschnittenen Konus (2) oder einer Pyramide vorliegen.

4. Sonde nach einem der Ansprüche 1 bis 3, wobei die Einrichtung zur Konzentrierung des zu messenden elektrischen Feldes aus einem isolierenden dielektrischen Material mit einer relativen Dielektrizitätskonstante von mindestens 100 hergestellt ist.

5. Sonde nach einem der Ansprüche 1 bis 3, wobei die Einrichtung zur Konzentrierung des zu messenden elektrischen Feldes aus einem leitenden Material mit einer Leitfähigkeit von mindestens 10⁶(Ωm)⁻¹ hergestellt ist.

6. Sonde nach einem der Ansprüche 1 bis 5, wobei der Signalkondensator (5) in Form einer oberflächenmontierten Komponente vorgesehen ist.

7. Sonde nach einem der Ansprüche 2 bis 5, wobei der Signalkondensator (5) in Form von Metallteilen der Abschneidungsabschnitte (3), die einander zugewandt sind, vorgesehen ist.

8. Sonde nach einem der Ansprüche 2 bis 5, wobei der Signalkondensator (5) auf einer isolierenden Membran (21) vorgesehen ist, und wobei die metallischen Elektroden des Signalkondensators (5) auf der Membran (21) ausgebildet und mit den Abschneidungsabschnitten (3) in Kontakt sind.

9. Sonde nach einem der Ansprüche 1 bis 8, die ferner umfasst:
einen oder mehrere Körper (23) mit einer Form, die komplementär zu derjenigen der konischen Körper (2) ist, aus Material mit einer relativen Dielektrizitätskonstante hergestellt sind, die nahe bei Eins liegt, und mit der konischen Oberfläche der konischen Körper (2) in Kontakt sind.

10. Sonde nach einem der Ansprüche 1 bis 9, die ferner umfasst:
zwei Erfassungseinrichtungen (6), wovon eine auf einer Basis (4) eines jeweiligen konischen Körpers (2) vorgesehen ist.

11. Sonde nach Anspruch 10, wobei die Erfassungseinrichtung (6) metallisch ist.

12. Sonde nach Anspruch 10, wobei die Erfassungseinrichtung (6) aus einem dielektrischen Material hergestellt ist.

13. Sonde nach einem der Ansprüche 1 bis 12, wobei eine Kompensationselektrode (8) in der Nähe der Basis (4) eines jeweiligen konischen Körpers (2) vorgesehen ist.

14. Sonde nach Anspruch 13, wobei die Kompensationselektroden (8) eine Öffnung in der Mitte haben und sowohl die äußere Form der Kompensationselektroden (8) als auch die Form der Öffnung der Form der Erfassungseinrichtung (6) entsprechen, wovon eine auf einer Basis (4) eines jeweiligen konischen Körpers (2) vorgesehen ist.

15. Sonde nach Anspruch 13 oder 14, wobei die Kompensationselektroden (8) in koplanarer Weise in Bezug auf die Erfassungseinrichtung (6) vorgesehen sind, wovon eine auf einer Basis (4) eines jeweiligen konischen Körpers (2) vorgesehen ist.

16. Sonde nach Anspruch 13 oder 14, wobei die Kompensationselektroden (8) auf der Seite der Erfassungseinrichtung (6) gegenüberliegend zu dem konischen Körper (2) vorgesehen sind, wobei eine dazwischenliegende isolierende Schicht (25) vorgesehen ist.

17. Sonde nach einem der Ansprüche 1 bis 16, wobei der Signalkondensator (5) ein dielektrisches Material mit nicht-linearem Antwortverhalten in Bezug auf ein elektrisches Feld umfasst.

18. Sensor mit der Sonde nach einem der Ansprüche 1 bis 17 und mit einem Elektrometer.

19. Sensor nach Anspruch 18, der ferner eine Einrichtung zum Schwingen oder Rotieren der Sonde entlang einer Achse hat, die senkrecht zu den Achsen der konischen Körper steht.

20. Sensor nach Anspruch 18 oder 19, wobei das Elektrometer eine Differenzverstärkerschaltung aufweist, die mit Elektroden des Signalkondensators (5) zur Verstärkung des Signals verbunden ist.

21. Sensor nach Anspruch 20, wobei Kompensationselektroden (8) mit der vollständig differentiellen Stufe der Verstärkungsschaltung verbunden sind.

## Revendications

1. Sonde pour mesurer des champs électriques, comprenant:
un moyen pour concentrer le champ électrique à mesurer; et
un condensateur de signal (5),
ladite sonde est **caractérisée en ce que** le moyen pour concentrer le champ électrique à mesurer comprend une structure de deux corps coniques (2) disposés de sorte que le champ électrique capturé sur une section de plus grand diamètre est guidé vers une section de diamètre plus petit, et le condensateur de signal (5) est un condensateur prévu entre les deux corps coniques (2).

2. Sonde selon la revendication 1, dans laquelle les corps coniques du moyen pour concentrer le champ électrique comportent un axe de symétrie, une base (4) et une section de troncature (3) avec une surface inférieure à celle de la base (4), l'axe de symétrie reliant le centre de la section de troncature (3) et le centre de la base (4) du corps conique, la section de troncature (3) et la base (4) étant perpendiculaires à l'axe de symétrie disposés avec les sections de troncature (3) opposées l'une à l'autre à une certaine distance et dont les axes coïncident; et le condensateur de signal (5) est relié électriquement aux sections de troncature (3).

3. Sonde selon les revendications 1 ou 2, dans laquelle les corps coniques du moyen de concentration du champ électrique ont la forme de cônes tronqués (2) ou de pyramides.

4. Sonde selon l'une des revendications 1 à 3, dans laquelle le moyen pour concentrer le champ électrique à mesurer est constitué d'un matériau diélectrique isolant avec une constante diélectrique relative d'au moins 100.

5. Sonde selon l'une des revendications 1 à 3, dans laquelle le moyen pour concentrer le champ électrique à mesurer est constitué d'un matériau conducteur avec une conductivité d'au moins 10⁶(Ωm)⁻¹.

6. Sonde selon l'une quelconque des revendications 1 à 5, dans laquelle le condensateur de signal (5) est prévu sous forme d'un composant monté en surface.

7. Sonde selon l'une quelconque des revendications 2 à 5, dans laquelle le condensateur de signal (5) est prévu sous forme de parties métallisées des sections de troncature (3) se faisant face l'une à l'autre.

8. Sonde selon l'une quelconque des revendications 2 à 5, dans laquelle le condensateur de signal (5) est prévu sur une membrane isolante (21), les électrodes métalliques du condensateur de signal (5) sont formées sur la membrane (21) et positionnées en contact avec les sections de troncature (3).

9. Sonde selon l'une des revendications 1 à 8 comprenant, en outre:
un ou plusieurs corps (23) de forme complémentaire à celle des corps coniques (2), constitués d'un matériau avec une constante diélectrique relative proche de l'unité, et en contact avec la surface conique des corps coniques (2).

10. Sonde selon l'une des revendications 1 à 9 comprenant, en outre:
deux moyens de capture (6), un étant prévu sur une base (4) de chaque corps conique (2).

11. Sonde selon la revendication 10, dans laquelle le moyen de capture (6) est métallique.

12. Sonde selon la revendication 10, dans laquelle les moyens de capture (6) sont constitués d'un matériau diélectrique.

13. Sonde selon l'une des revendications 1 à 12, dans laquelle une électrode de compensation (8) est prévue à proximité de la base (4) de chaque corps conique (2).

14. Sonde selon la revendication 13, dans laquelle les électrodes de compensation (8) ont une ouverture au centre , et à la fois la forme extérieure des électrodes de compensation (8) et la forme de l'ouverture correspondent à la forme des moyens de capture (6), un étant prévu sur une base (4) de chaque corps conique (2).

15. Sonde selon les revendications 13 ou 14, les électrodes de compensation (8) sont prévues de manière coplanaire avec les moyens de capture (6), une étant prévue sur une base (4) de chaque corps conique (2).

16. Sonde selon l'une quelconque des revendications 13 ou 14, dans laquelle les électrodes de compensation (8) sont prévues sur le côté des moyens de capture (6) opposés au corps conique (2) avec une couche isolante intermédiaire (25).

17. Sonde selon l'une quelconque des revendications 1 à 16, dans laquelle le condensateur de signal (5) comprend un matériau diélectrique avec une réponse non linéaire à un champ électrique.

18. Capteur comprenant la sonde selon l'une quelconque des revendications 1 à 17 et un électromètre.

19. Capteur selon la revendication 18, comprenant en outre un moyen pour faire vibrer ou faire tourner la sonde le long d'un axe perpendiculaire aux axes des corps coniques.

20. Capteur selon les revendications 18 ou 19, dans lequel l'électromètre comprend un circuit d'amplification différentielle connecté aux électrodes du condensateur de signal (5) pour amplifier le signal.

21. Capteur selon la revendication 20, dans lequel des électrodes de compensation (8) sont connectées à l'étage entièrement différentiel du circuit d'amplification.
